Europäisches Patentamt

European Patent Office

Office européen des brevets

(19)

(11) **EP 0 395 017 B1**

(12) **EUROPEAN PATENT SPECIFICATION**

(45) Date of publication and mention
of the grant of the patent:
**25.09.1996 Bulletin 1996/39**

(51) Int Cl.6: **H01L 21/311**, H01L 21/321,
H01J 37/32

(21) Application number: **90107870.9**

(22) Date of filing: **25.04.1990**

(54) **Plasma etching method**

Plasma-Ätzmethode

Méthode d'attaque par plasma

(84) Designated Contracting States:
**DE GB IT**

(30) Priority: **25.04.1989 JP 106931/89**

(43) Date of publication of application:
**31.10.1990 Bulletin 1990/44**

(73) Proprietor: **TOKYO ELECTRON LIMITED**
**Shinjuku-ku Tokyo (JP)**

(72) Inventors:
• **Kojima, Hiroshi**
 **Machida-shi, Tokyo (JP)**
• **Tahara, Yoshifumi**
 **Yamato-shi, Kanagawa-ken (JP)**

• **Arai, Izumi**
 **Yokohama-shi (JP)**

(74) Representative: **Lehn, Werner, Dipl.-Ing. et al**
**Hoffmann, Eitle & Partner,**
**Patentanwälte,**
**Postfach 81 04 20**
**81904 München (DE)**

(56) References cited:
**EP-A- 0 047 395      EP-A- 0 089 382**
**EP-A- 0 353 719      WO-A-86/03887**

Remarks:
The file contains technical information submitted
after the application was filed and not included in this
specification

## Description

A method of adjusting the selection ratio achieved during plasma etching of an object (42) having a first layer (52,62) to be etched and a second layer (50,60) where said selection ratio denotes the ratio of the etching rate of said first layer (52,62) to the etching rate of said second layer (50,60) comprising the steps of:

introducing an etching gas into the region between the two electrodes;

generating plasma of said etching gas by applying a predetermined electric power between said electrodes; and

etching said object to be processed by said plasma.

In parallel plane-typed plasma etching apparatus, RF power is applied to an upper electrode, whilst a lower electrode supporting a wafer is grounded. An etching gas is introduced between both electrodes and plasma is induced, thereby etching the wafer.

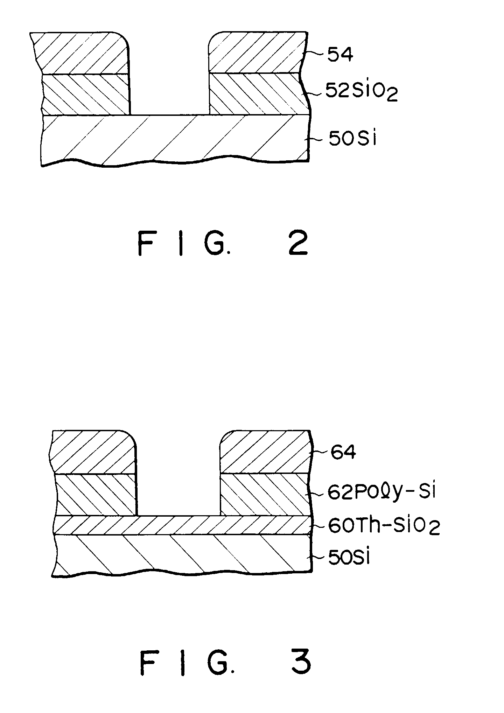

For example, as shown in Figure 2 of the accompanying drawings, where an oxide film ($SiO_2$) 52, formed on a Si substrate 50 is etched, the etching is performed in such a manner that the portions to remain unetched are masked by a masking member 54 before etching gas is introduced.

In this case, there is a need for the selection ratio (defined below) to be improved.

$$\text{Selection Ratio} = \frac{\text{Etching Rate of SiO}_2}{\text{Etching Rate of Si}}$$

Improvements in the etching rate of $SiO_2$, (relative to Si) have conventionally been made by the selection of etching gas.

As mentioned above, since the element, which determines the etching characteristics, conventionally depended on the selection of etching gas, there was a problem in that if a different etching gas was selected, this had a great influence on the other etching characteristics, e.g. uniformity.

An object of the present invention is to provide a plasma etching method which can provide uniform plasma etching independent of selection of etching gas.

According to the invention, the plasma etching method initially defined is characterized by adjusting the area of said second electrode in contact with said etching gas by changing the opening diameter of an insulating shield ring which covers said second electrode in order to adjust the selection ration during etching of said object to be processed, where said selection ratio denotes the ratio of the etching rate of said first layer to the etching rate of said second layer.

This invention can be more fully understood from the following detailed description when taken in conjunction with the accompanying drawings, in which:

Figure 1 is a schematic view of an embodiment of a plasma etching apparatus used in the present invention;

Figure 2 is a schematic cross-sectional view showing processing of a member where selective etching of $SiO_2$ is performed; and

Figure 3 is a schematic cross-sectional view showing processing of a member where selective etching of a polysilicon film is performed.

An embodiment of the present invention will be explained with reference to the drawings.

In plasma etching apparatus, the etching function may be roughly classified into chemical reaction caused by radicals (free radicals) generated in the plasma and a physical function in which ions, arising when gas molecules are decomposed, collide with the material to be etched.

Particularly, a layer to be etched such as an oxide film layer is more strongly etched by the physical effect of ion bombardment than by chemical reaction with plasma.

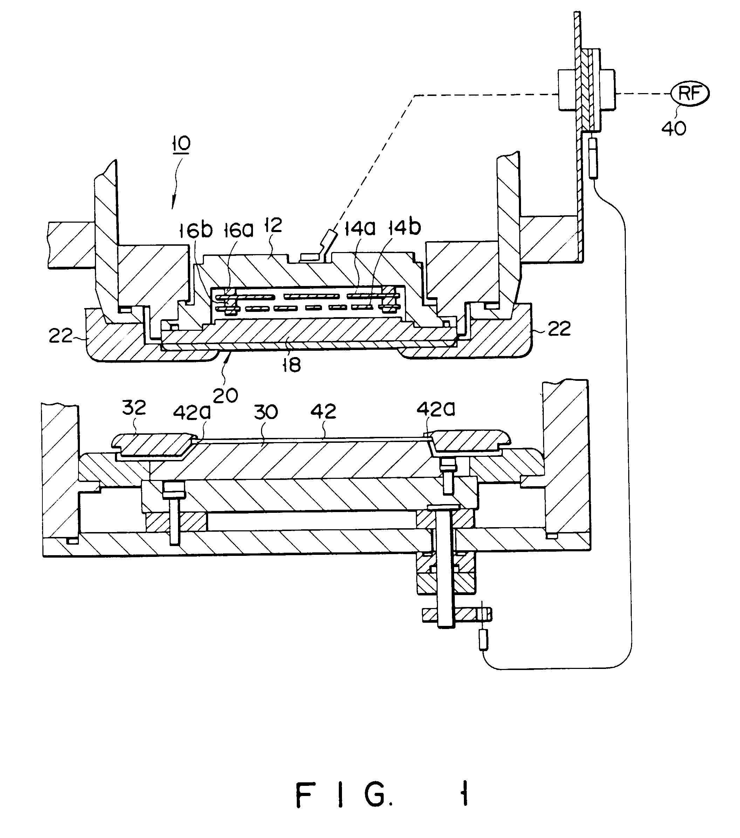

In Figure 1, the plasma etching apparatus comprises an upper electrode 10 and a lower electrode 30, which are arranged to be opposite to each other in a reaction chamber. A wafer 42, which is to be etched is mounted on the lower electrode 30. Moreover, RF power, e.g., 380 KHz is applied between the upper electrode 10 and the lower electrode 30. Then, etching gas is introduced into the reaction chamber through a porous portion formed on the upper electrode 10, and plasma is generated between the upper electrode 10 and the lower electrode 30, thereby performing etching of the wafer 42.

The upper electrode 10 has a flanged conductive cooling member 12. A cable from RF power source 40 is connected to the cooling member 12.

Also, first and second perforated diffusion plates 14a and 14b are arranged in parallel by means of spacers 16a and 16b. Moreover, to cover the opening of the cooling member 12, a reinforcing plate 18, and an amorphous carbon electrode 20 are laminated thereon. Additionally, there is provided a shield ring 22 in order to cover the periphery of the amorphous carbon electrode 20, and to define the exposed portion of the amorphous carbon electrode 20 in contact with the plasma.

The lower electrode 30 carries a wafer 42, which is to be etched, on the upper surface, of a projecting discoid portion thereof. In order to connect and secure the periphery 42a of the wafer 42 to the lower electrode 30 an annular clamp 32 is arranged around the lower electrode 30. Additionally, the lower electrode 30 is electrically grounded.

As mentioned above, the upper electrode 10 and the lower electrode 30 are spaced from each other in the chamber, thereby constituting the parallel plane-type etching apparatus.

As a characteristic structure of this embodiment, the opening diameter of the shield ring 22 is determined so as to obtain uniform etching of the portion to be etched. For example, where the etching selection ratio of a layer to be etched such as $SiO_2$ is increased, a shield ring 22 having a small opening diameter is employed.

Operation of this apparatus will be explained as follows.

In the above apparatus, RF power from the RF power source 40 is applied between the upper electrode 10 and the lower electrode 30 and etching gas is introduced above the lower electrode via the upper electrode 10. Thereby, plasma is induced between the upper and lower electrodes 10 and 30, and radicals generated in the plasma adhere to the surface of wafer 42, so that a chemical reaction is promoted. Moreover, ions in the plasma are accelerated by the electric field formed between the parallel plate-shaped electrodes. Thereby, ions collide with the wafer 42 and etching of the wafer 42 is performed. By the use of this type of parallel plate-shaped etching apparatus, anisotropic etching, in which side etching is reduced, can be performed and a fine pattern etching can be realized.

Therefore, etching by the physical function, in which ions are accelerated and collide with the surface of the wafer 42, contributes more to the etching of oxide film 52 shown in Figure 2 than chemical reaction by radicals.

In this embodiment, by promoting etching based on the physical effect of the ions, the etching selection ratio (VsSi) of the oxide film 52 is increased and improved.

The shield ring 22 is formed of an insulating member such as quartz, ceramic, etc. For this reason, if the opening diameter of the shielding ring 22 is narrowed, an area contributing to plasma of the amorphous carbon electrode 20 is narrowed down to the central portion. Therefore, plasma is focused on the central position opposite to the wafer 42.

As a result, if ions generated in plasma are accelerated between these electrodes, the ratio in which the ion concentrates on $SiO_2$ layer 52 of the wafer 42, is raised, thereby the etching selection of the $SiO_2$ can be improved.

On the other hand, in a case where the etching selection ratio is lowered, the opening diameter of the shielding ring 22 may be increased.

For example, in a case where the polysilicon film 62 of material to be etched having a thermal oxide film (Th-$SiO_2$)60 and polysilicon film 62 (Poly-Si) formed on a Si substrate 50 is masked by a masking member 64 and etched as shown in Figure 3, so that uniform etching of the polysilicon film is obtained. In this case the selection ratio of the etching is defined below.

$$\text{Selection Ratio} = \frac{\text{Etching Rate of Polysilicon}}{\text{Etching Rate of Ground Th-SiO2}}$$

In this case, in order to control the etching selection ratio of the thermal oxide film 60 the degree of the concentration of plasma on the wafer 42 may be reduced by widening the opening diameter of the shield ring 22.

In the present invention, not only polysilicon film but also the other film may be etched.

As has been described, the opening diameter of the shield ring, which determines the degree of focus of plasma, is selected so as to obtain uniform etching. For example, where the uniformity of the etching, which is etched under the influence of the physical function by ions, is improved, an area of the contact surface of the electrode contacting the etching gas is decreased by making the opening diameter small, thereby plasma is concentrated on the processing material.

Reference signs in the claims are intended for better understanding and shall not limit the scope.

**Claims**

1. A plasma etching method, comprising the steps of:

   mounting an object (42) to be processed in a region formed between a first electrode (30) and a second electrode (10), said object (42) having a first layer (52,62) to be etched and a second layer (50,60);
   introducing an etching gas into said region;
   generating a plasma of said etching gas by applying a predetermined electric power between said first and second electrodes (30,10); and
   etching said object (42) to be processed by said plasma;

   characterised in that the area of said second electrode (10) in contact with said etching gas is adjusted by changing the opening diameter of an insulating shield ring (22), which covers said second electrode (10), in order to adjust the selection ratio during etching of said object (42) to be processed, where said selection ratio denotes the ratio of the etching rate of said first layer (52,62) to the etching rate of said second layer (50,60).

2. A method according to claim 1, wherein said second layer (50,60) is located beneath said first layer (52,62).

3. A method according to claim 1 or 2, wherein said first and second layers (52,50) are substantially formed of SiO2 and Si, respectively.

4. A method according to claim 1 or 2, wherein said first and second layers (62,60) are substantially formed of poly-Si and thermal SOi2, respectively.

**Patentansprüche**

1. Plasma-Ätzverfahren, umfassend die folgenden Schritte:

   Anbringen eines zu bearbeitenden Objekts (42) in einem Bereich, der zwischen einer ersten Elektrode (30) und einer zweiten Elektrode (10) gebildet ist, wobei das Objekt (42) eine erste zu ätzende Schicht (52, 62) und eine zweite Schicht (50, 60) aufweist;

Einleiten eines Ätzgases in den Bereich;

Erzeugen eines Plasmas des Ätzgases durch Anlegen einer vorgegebenen elektrischen Energie zwischen die ersten und zweiten Elektroden (30, 10); und

Ätzen des Objekts (42), welches mit dem Plasma bearbeitet werden soll;

dadurch gekennzeichnet, daß die Fläche der Elektrode (10), die in Kontakt mit dem Ätzgas ist, eingestellt wird, indem der Öffnungsdurchmesser eines isolierenden Abschirmungsrings (22) verändert wird, der die zweite Elektrode (10) abdeckt, um das Selektionsverhältnis während eines Ätzens des zu bearbeitenden Objekts (42) einzustellen, wobei das Selektionsverhältnis das Verhältnis der Ätzrate der ersten Schicht (52, 62) zu der Ätzrate der zweiten Schicht (50, 60) bezeichnet.

2. Verfahren nach Anspruch 1, dadurch gekennzeichnet, daß sich die zweite Schicht (50, 60) unter der ersten Schicht (52, 62) befindet.

3. Verfahren nach Anspruch 1 oder 2, dadurch gekennzeichnet, daß die ersten und zweiten Schichten (52, 50) im wesentlichen aus $SiO_2$ bzw. Si gebildet sind.

4. Verfahren nach Anspruch 1 oder 2, dadurch gekennzeichnet, daß die ersten und zweiten Schichten (62, 60) im wesentlichen aus Poly-Si bzw. thermischem $SiO_2$ gebildet sind.

**Revendications**

1. Procédé de décapage au plasma, comprenant les étapes consistant à:

monter un objet (42) à traiter dans une région formée entre une première électrode (30) et une deuxième électrode (10), ledit objet (42) présentant une première couche (52, 62) à décaper et une seconde couche (50, 60);
introduire un gaz de décapage dans ladite région;
produire un plasma dudit gaz de décapage, en appliquant une énergie électrique prédéterminée entre ladite première et ladite deuxième électrode (30, 10); et

décaper ledit objet (42) à traiter, au moyen dudit plasma;

caractérisé en ce que la superficie de ladite deuxième électrode (10) en contact avec ledit gaz de décapage est ajustée en modifiant le diamètre d'ouverture d'une bague-écran isolante (22) qui couvre ladite deuxième électrode (10), de manière à ajuster le rapport de sélection pendant le décapage dudit objet (42) à traiter, où ledit rapport de sélection désigne le rapport de la vitesse de décapage de ladite première couche (52, 62) à la vitesse de décapage de ladite deuxième couche (50, 60).

2. Procédé selon la revendication 1, dans lequel ladite deuxième couche (50, 60) est située en dessous de ladite première couche (52, 62).

3. Procédé selon la revendication 1 ou 2, dans lequel ladite première et ladite deuxième couche (52, 50) sont respectivement formées essentiellement de $SiO_2$ et de Si.

4. Procédé selon la revendication 1 ou 2, dans lequel ladite première et ladite deuxième couche (62, 60) sont respectivement formées essentiellement de poly-Si et de $SiO_2$ thermique.

F I G. 1

~ 54

52 SiO$_2$

~ 50 Si

# F I G. 2

~ 64

62 Poly-Si

60 Th-SiO$_2$

~ 50 Si

# F I G. 3